# EUROPEAN PATENT SPECIFICATION

(11) **EP 3 693 993 B1**
(45) Date of publication and mention of the grant of the patent: **09.07.2025**
(21) Application number: 19156506.8
(22) Date of filing: 11.02.2019
(51) Int. Cl.: H10D 86/00, H10D 89/60, H01L 21/762

(54) **SEMICONDUCTOR DEVICE INCLUDING PROTECTION STRUCTURE AND MANUFACTURING METHOD THEREFOR**
HALBLEITERBAUELEMENT MIT SCHUTZSTRUKTUR UND HERSTELLUNGSVERFAHREN DAFÜR
DISPOSITIF À SEMI-CONDUCTEUR COMPRENANT UNE STRUCTURE DE PROTECTION ET SON PROCÉDÉ DE FABRICATION

(43) Date of publication of application: 12.08.2020
(73) Proprietor: Infineon Technologies AG, 85579 Neubiberg (DE)
(72) Inventor: Barrenscheen, Jens, 81669 München (DE)
(74) Representative: Müller Hoffmann & Partner

(56) References cited:
- EP-A1- 1 111 675
- JP-A- 2007 287 883
- US-A1- 2003 137 009
- US-A1- 2009 085 117

## Description

### TECHNICAL FIELD

The present disclosure is related to semiconductor devices, in particular to semiconductor devices including a protection structure and manufacturing methods therefor.

### BACKGROUND

In power conversion applications, electronic circuits, such as gate drivers, and one or more power switches are needed that do not refer to different reference potentials. To allow signal transfer between the parts of the circuits that do not refer to the same reference potential, level shifter structures are used. Power switches may be controlled by an electronic circuit located in an active area (area of the device that contains active electronic components, e.g. transistors). If one active area does not refer to the same reference potential as another active area, level shifters transfer information between the two active areas. Typically, an integrated level shifter is implemented using at least a part of the semiconductor area surrounding an active area, wherein the level shifter is arranged parallel to a voltage drop (potential difference between two active areas). In order to support the required potential drop, the level shifter thus may require a large semiconductor area. Moreover, components such as level shifter elements, transistors, diodes, resistors, electro-optical devices, precision film resistors and a variety of integrated circuits are all sensitive to ElectroStatic Discharge (ESD), and as electronics manufacturers drive to miniaturize devices and improve operating speeds, susceptibility of devices to ESD is increasing. Devices are subject to ESD damage at every stage of production: from wafer fabrication to populated circuit boards in sub-assemblies and assemblies. Also during operation of components or integrated circuits unwanted voltage pulses may arise. In automotive chips, unwanted voltage pulses may be caused by the vehicle wiring any may damage sensitive subsystems such as safety systems, control modules and infotainment equipment. Pulses can be caused by events such as electrostatic discharges (ESD) from occupants, turn-on/off of subsystems such as motor drives or climate control, or overvoltage may occur due to load dumps when a significant load such as the battery or starter motor is suddenly disconnected. Pulses may also be caused by mounting techniques of single electronic components (such as integrated circuits) to build an ECU (electronic control unit) during the manufacturing process. For avoiding damage to integrated circuits or electronic devices by pulses during assembly or operation, ESD protection devices, e.g. SCRs are connected between pins of an integrated circuit in order to prevent a malfunction or electric breakdown of circuits connected between the pins by pulses.

Document JP 2007 287883 A relates to a semiconductor device in which each insulating isolation trench between respective field regions is hardly broken down, even if a high-voltage dV/dt surge is applied. The semiconductor device is configured in such a way that multilayer field regions are formed of multilayer first insulating isolation trenches. In the device, a power source potential field region is insulated and separated from a transistor element arrangement field region adjacent thereto by first insulating isolation trenches. In the device, a GND potential field region is insulated and separated from a transistor element arrangement field region adjacent thereto by first insulating isolation trenches.

Document US 2003 / 0 137 009 A1 discloses a protection structure against electrostatic discharges for a semiconductor electronic device that is integrated inside a well, wherein the well is formed on a SOI substrate and isolated dielectrically by a buried oxide layer and an isolation structure, which isolation structure includes in turn at least a dielectric trench filled with a filler material. Advantageously, the protection structure is formed at the isolation structure.

There is a need to improve semiconductor devices in view of chip size and switching speed while maintaining ESD protection.

### SUMMARY

The invention is defined by the appended claims. References to embodiments which do not fall under the scope of the claims are to be understood as examples useful for understanding the invention.

An example of the present disclosure relates to a semiconductor device. The semiconductor device comprises an isolation structure, a first active area formed on the isolation structure, a protection area formed on the isolation structure and laterally surrounding the first active area, and a second active area formed on the isolation structure and laterally surrounding the protection area. The semiconductor device further comprises a first trench isolation structure electrically separating the first active area and the protection area, and a second trench isolation structure electrically separating the protection area and the second active area. The semiconductor device further comprises a protection structure in the protection area. A first pin of the protection structure is electrically connected to the first active area and a second pin of the protection structure is electrically connected to the second active area.

Another example of the present disclosure relates to a semiconductor device. The semiconductor device comprises an isolation structure, a first active area formed on the isolation structure, and a second active area formed on the isolation structure. The semiconductor device further comprises a trench isolation structure electrically separating the first active area and the second active area. The semiconductor device further comprises two or more device elements in the second active area, wherein the two or more device elements are connected in series. The two or more device elements are arranged substantially along a sidewall of the trench isolation structure, in particular parallel to an extension direction of the sidewall. The direction parallel to the sidewall the trench isolation structure may be the direction of equal electrical potential surrounding the trench isolation structure.

Another example of the present disclosure relates to a method of manufacturing a semiconductor device. The method includes providing a semiconductor body comprising an isolation structure, a first active area formed on the isolation structure, a protection area formed on the isolation structure and laterally surrounding the first active area, and a second active area formed on the isolation structure and laterally surrounding the protection area. The method further comprises forming a first trench isolation structure. The first trench isolation structure electrically separates the first active area and the protection area. The method further comprises forming a second trench isolation structure. The second trench isolation structure electrically separates the protection area and the second active area. The method further comprises forming a protection structure in the protection area. The method further comprises electrically connecting a first pin of the protection structure to the first active area. The method further comprises electrically connecting a second pin of the protection structure to a second active area.

Another example of the present disclosure relates to a method of manufacturing a semiconductor device. The method includes providing a semiconductor body comprising an isolation structure, a first active area formed on the isolation structure and a second active area formed on the isolation structure. The method further includes forming a trench isolation structure. The trench isolation structure electrically separates the first active area and the second active area. The method further includes forming two or more device elements in the second active area and electrically connecting the device elements in series. The two or more device elements are arranged substantially along a sidewall of the trench isolation structure.

Those skilled in the art will recognize additional features and advantages upon reading the following detailed description and on viewing the accompanying drawings.

### BRIEF DESCRIPTION OF THE DRAWINGS

The accompanying drawings are included to provide a further understanding of the present embodiments and are incorporated in and constitute a part of this specification. The drawings illustrate the present embodiments of the semiconductor device and the method of manufacturing a semiconductor device, and together with the description serve to explain principles of the embodiments. Further embodiments and intended advantages will be readily appreciated as they become better understood by reference to the following detailed description. Further embodiments are described in the following detailed description and the claims.
FIG. 1A illustrates a schematic plan view of an embodiment of a semiconductor device including a protection area and active areas.
FIG. 1B illustrates a schematic cross-sectional view along an intersection line AA' of FIG. 1A.
FIG. 2 is a schematic plan view of an embodiment of a semiconductor device including protection sub-areas.
FIG. 3 is a schematic view of a protection structure including protection elements serially connected.
FIGS. 4 to 8 illustrate plan views of embodiments of semiconductor devices.
FIG. 9A illustrates a schematic plan view of an embodiment of a semiconductor device including a first active area and two or more device elements in a second active area.
FIG. 9B illustrates a schematic cross-sectional view along an intersection line BB' of FIG. 9A.

### DETAILED DESCRIPTION

In the following detailed description, reference is made to the accompanying drawings, which form a part thereof and in which are shown by way of illustrations specific embodiments in which a semiconductor device may be practiced. It is to be understood that other embodiments may be utilized and structural or logical changes may be made without departing from the scope of the present disclosure. For example, features illustrated or described for one embodiment can be used on or in conjunction with other embodiments to yield yet a further embodiment. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude additional elements or features. The articles "a", "an" and "the" are intended to include the plural as well as the singular, unless the context clearly indicates otherwise.

The term "electrically connected" describes a permanent low-resistive connection between electrically connected elements, for example a direct contact between the concerned elements or a low-resistive connection via a metal and/or heavily doped semiconductor material. The term "electrically coupled" includes that one or more intervening element(s) adapted for signal and/or power transmission may be between the electrically coupled elements, for example, elements that are controllable to temporarily provide a low-resistive connection in a first state and a high-resistive electric decoupling in a second state.

Ranges given for physical dimensions include the boundary values. For example, a range for a parameter y from a to b reads as a ≤ y ≤ b. A parameter y with a value of at least c reads as c ≤ y and a parameter y with a value of at most d reads as y ≤ d.

A safe operating area (SOA) defines voltage and current conditions over which a semiconductor device can be expected to operate without self-damage. The SOA is given by published maximum values for device parameters like maximum continuous load current, maximum gate voltage and others.

According to an embodiment of a semiconductor device, the semiconductor device may include an isolation structure. The semiconductor device may further include a first active area formed on the isolation structure, a protection area formed on the isolation structure and laterally surrounding the first active area, a second active area formed on the isolation structure and laterally surrounding the protection area. The semiconductor device may further include a first trench isolation structure electrically separating the first active area and the protection area. The semiconductor device may further include a second trench isolation structure electrically separating the protection area and the second active area. The semiconductor device may further include a protection structure in the protection area, wherein a first pin of the protection structure may be electrically connected to the first active area and a second pin of the protection structure may be electrically connected to the second active area.

In some embodiments, the isolation structure may be formed on a substrate. Each one or a combination of the substrate, the first active area, the protection area and the second active area may include or consist of a semiconductor material from the group IV elemental semiconductors, IV-IV compound semiconductor material, III-V compound semiconductor material, or II-VI compound semiconductor material. Examples of semiconductor materials from the group IV elemental semiconductors include, inter alia, silicon (Si) and germanium (Ge). Examples of IV-IV compound semiconductor materials include, inter alia, silicon carbide (SiC) and silicon germanium (SiGe). Examples of III-V compound semiconductor material include, inter alia, gallium arsenide (GaAs), gallium nitride (GaN), gallium phosphide (GaP), indium phosphide (InP), indium gallium nitride (InGaN) and indium gallium arsenide (InGaAs). Examples of II-VI compound semiconductor materials include, inter alia, cadmium telluride (CdTe), mercury-cadmium-telluride (CdHgTe), and cadmium magnesium telluride (CdMgTe). The substrate may also be formed by a material different from a semiconductor material, for example. In some other embodiments, the substrate may be removed during a manufacturing process of the semiconductor device. Hence, the isolation structure may be formed at a bottom side of the semiconductor device that may be mounted on a carrier, for example.

The first active area, the second active area and the protection area may be parts of a semiconductor layer or a semiconductor layer stack that is formed over the isolation structure, for example.

The protection area laterally surrounding the first active area may be formed as a first closed loop, wherein the first active area may be arranged within the first closed loop with respect to a top view of the semiconductor device. The second active area may be arranged outside of the first closed loop with respect to a top view of the semiconductor device. Likewise, the second active area may be formed as a second closed loop, wherein the first active area and the protection area may be arranged within second the closed loop with respect to a top view of the semiconductor device. The first trench isolation structure may also be formed as a closed loop laterally arranged between the first active area and the protection area. Likewise, the second trench isolation structure may also be formed as a closed loop laterally arranged between the protection area and the second active area.

The isolation structure may be formed of one or a combination of materials configured to electrically separate the substrate and semiconductor regions, e.g. active areas or protection areas formed on the isolation structure. The isolation structure may be a pn-junction isolation structure, for example. In this case, the isolation structure may be a p-doped region arranged between an n-doped substrate and n-doped active areas, or an n-doped region arranged between p-doped substrate and p-doped active areas. The isolation structure may also be a dielectric structure including one or more dielectric materials. Examples of dielectric materials comprise oxides, e.g. silicon oxide, nitrides, e.g. silicon nitride, high-k and low-k dielectrics. The substrate, the isolation structure and the active areas formed on the isolation structure may be part of a silicon on insulator (SOI) substrate, for example.

Each of the first and second trench isolation structures may include a trench that extends from a surface of the active areas at least to the isolation structure. The trench may be completely filled with one or more dielectric materials, e.g. oxides, e.g. silicon oxide, nitrides, e.g. silicon nitride, high-k dielectrics, and low-k dielectrics. The one or more dielectric materials may also line sidewalls of the trench, wherein the trench may further include one or more conductive fillings, e.g. metals, metal alloys, silicides, doped semiconductor materials, or any combination thereof. The one or more dielectric materials lining the sidewalls of the trench may electrically insulate the one or more conductive fillings and surrounding active areas/protection areas, for example. In this case, the trench may extend through the isolation structure up to or into the substrate. The one or more conductive fillings may be electrically connected to the substrate. Thereby, the trench isolation structures may not only electrically separate the protection area from neighboring active areas, but may also allow for electrically connecting the substrate via a first main surface, e.g. a front side of the semiconductor device, for example.

The protection structure may include one or more protection elements configured to protect circuit elements in the first and second active areas from ESD pulses between a first circuit pin electrically connected to circuit elements in the first active area and a second circuit pin electrically connected to circuit elements in the second active area.

The semiconductor devices described herein allow for the technical advantage of operating the circuit elements in the first and second active areas at voltage differences that may be larger than a breakdown voltage of each of the first and second trench isolation structures while providing on-chip ESD protection between the first and second active areas.

The protection device and the circuit elements formed in the first and second active areas may be formed by a CMOS (Complementary Metal Oxide Semiconductor) technology or by a family of processes, each of which combines the strengths of different process technologies onto a single chip: Bipolar for precise analog functions, CMOS (Complementary Metal Oxide Semiconductor) for digital design and DMOS (Double Diffused Metal Oxide Semiconductor) for power and high-voltage elements. These mixed processes are also known as BCD (Bipolar CMOS DMOS) technology or Smart Power Technology (SPT).

According to the claimed invention, the protection structure comprises a plurality of protection elements electrically connected in series. The protection elements may be uni- or bi-directional protection elements. The protection structure may also include a combination of uni- and bi-directional protection elements. Examples of protection elements include diodes, e.g. Zener breakdown diodes or avalanche breakdown diodes, silicon controlled rectifiers, bipolar transistors, active clamped transistor devices, for example. Each protection element may be operated up to maximum voltage ratings. The protection structure may include protection elements having different maximum voltage ratings. The protection elements may be connected in series in an appropriate way to i) withstand voltage differences occurring between the first and second pins during operation of the circuits in the first and second active areas, and to ii) provide a discharge path for ESD pulse currents between the first and second circuit pins before an ESD current leads to damage of the circuit elements electrically connected to the first and second circuit pins.

According to the claimed invention, each of or groups of the plurality of protection elements is laterally surrounded by a device isolation structure. According to examples not falling within the scoped of the claimed invention, the device isolation structure may be a pn-junction isolation structure, for example. In this case, the device isolation structure may be a p-doped region arranged between n-doped active area parts, or an n-doped region arranged between p-doped active area parts. According to the claimed invention, the device isolation structure is a dielectric structure including one or more dielectric materials. Examples of dielectric materials comprise oxides, e.g. silicon oxide, nitrides, e.g. silicon nitride, high-k and low-k dielectrics. In this case, the device isolation structure may be concurrently formed with the first and second trench isolation structures. Breakdown voltages and widths of the first and second trench isolation structures may correspond to one another.

According to an embodiment of the semiconductor device, a part of the device isolation structure of at least one of the plurality of protection elements may correspond to a part of the first trench isolation structure.

According to the claimed invention, the plurality of protection elements are consecutively arranged along a first lateral direction and serially connected to one another along the first lateral direction. This may allow for a compact and area-saving arrangement of the protection elements in the protection area. Thereby, a total area of the protection area surrounding the first active area may be reduced or minimized.

According to an example not falling within the scope of teh claimed invention, the plurality of protection elements may be arranged in a meandering configuration and serially connected to one another along the meandering configuration.

According to an embodiment of the semiconductor device, the device isolation structure may comprise a third trench isolation structure, and a width of the third trench isolation structure may correspond to a width of each of the first and second trench isolation structures. The first to third trench isolation structures may be concurrently formed and may have a same breakdown voltage or blocking voltage capability, for example.

According to an embodiment of the semiconductor device, the protection area may comprise at least one pair of protection sub-areas. A first protection sub-area of each pair of the at least one pair laterally may surround a second protection sub-area of the respective pair. The semiconductor device may further comprise a fourth trench isolation structure arranged between the first protection sub-area and the second protection sub-area. By dividing the protection area into several protection sub-areas electrically separated from one another by a trench isolation structure having a specific breakdown voltage, a voltage blocking capability of the protection structure may be adjusted to a maximum voltage difference that may occur between the first and second circuit pins when operating the semiconductor device within the SOA.

According to an embodiment of the semiconductor device, the protection structure may comprise a first number of serially connected protection elements in the first protection sub-area and a second number of serially connected protection elements in the second protection sub-area. The first number of serially connected protection elements may be adjusted depending on a breakdown voltage or blocking voltage capability of the trench isolation structures and the maximum voltage ratings of each of the serially connected protection elements. Likewise, the second number of serially connected protection elements may be adjusted depending on a breakdown voltage or blocking voltage capability of the trench isolation structures and the maximum voltage ratings of each of the serially connected protection elements. Total maximum voltage ratings of the first and second number of serially connected protection elements may be adjusted smaller, e.g. slightly smaller than the breakdown voltage or blocking voltage capability of the trench isolation structures, for example. Thus, an electric breakdown of one of the trench isolation structures adjoining a respective protection sub-area can be avoided.

According to an embodiment of the semiconductor device, the first number may be equal to the second number. According to an embodiment, the protection structure may be formed by a serial connection of only one type of protection elements, for example.

According to an embodiment of the semiconductor device, the first number of protection elements may be consecutively arranged along the first lateral direction, and the second number of protection elements may be consecutively arranged along the first lateral direction having a lateral offset to the first number of protection elements. The lateral offset may be an offset along a second lateral direction perpendicular to the first lateral direction.

According to an embodiment, the semiconductor device may further comprise a level shifter structure in the protection area. The level shifter structure may comprise cascaded level shifter elements. The number of level shifter elements may correspond to the number of protection elements in all or some of the protection sub-areas, for example. Level shifter elements may be arranged together with protection elements in a common part of the protection area that is surrounded by a common trench isolation structure, for example. When using cascaded level shifter elements, the voltage capability of each single switch is much less than the overall voltage requirements for the complete level shifter structure.

According to an embodiment, the semiconductor device may further comprise a high side gate driver circuit in the first active area and a low side gate driver circuit in the second active area. The semiconductor device may be part of an electronic circuit, e.g. a high power DC/DC converter, high voltage (VH) motor drives, circuits connected to grid, for example. The electronic circuits may be used in automotive applications, e.g. hybrid or full-electric vehicles, for example.

According to an embodiment of a semiconductor device, the semiconductor device may include an isolation structure. The semiconductor device may further include a first active area formed on the isolation structure and a second active area formed on the isolation structure. The semiconductor device may further include a trench isolation structure electrically separating the first active area and the second active area. The semiconductor device may further include two or more device elements in the second active area, wherein the two or more device elements may be connected in series. The two or more device elements may be substantially arranged along a sidewall of the trench isolation structure, e.g. parallel to an extension direction of the sidewall. A breakdown voltage or voltage blocking capability of the two or more device elements, i.e. a sum of breakdown voltages or voltage blocking capabilities of the device elements connected in series may be smaller than a breakdown voltage or voltage blocking capability of the trench isolation structure.

According to an embodiment of the semiconductor device, the device elements may be level shifter elements. Stacking of level shifter elements parallel to the extension direction of the sidewall of the trench isolation structure may allow for a compact layout compared with a layout where a level shifter is required to be arranged along a direction of voltage drop. This technical benefit may be achieved by electrically separating the first and second active areas by the trench isolation structure. Stacking of multiple low voltage level shifter elements may further allow for a faster circuit operation, for example.

According to an embodiment of the semiconductor device, the device elements may be protection elements.

According to an embodiment, a method of manufacturing a semiconductor device may comprise providing a semiconductor body comprising an isolation structure, a first active area formed on the isolation structure, a protection area formed on the isolation structure and laterally surrounding the first active area, and a second active area formed on the isolation structure and laterally surrounding the protection area. The method may further comprise forming a first trench isolation structure, wherein the first trench isolation structure electrically separates the first active area and the protection area. The method may further comprise forming a second trench isolation structure, wherein the second trench isolation structure electrically separates the protection area and the second active area. The method may further comprise forming a protection structure in the protection area. The method may further comprise electrically connecting a first pin of the protection structure to the first active area, and electrically connecting a second pin of the protection structure to the second active area.

According to the claimed invention the method further comprises a plurality of protection elements electrically connected in series, and forming a device isolation structure laterally surrounding each of or groups of the plurality of protection elements.

According to an embodiment of the method, the device isolation structure is a third trench isolation structure.

According to an embodiment, the method may further comprise subdividing the protection area into at least one pair of protection sub-areas by forming a fourth trench isolation structure arranged between a first protection sub-area and a second protection sub-area of each pair of the at least one pair.

According to an embodiment, a method of manufacturing a semiconductor device may include providing a semiconductor body comprising an isolation structure, a first active area formed on the isolation structure and a second active area formed on the isolation structure. The method may further include forming a trench isolation structure. The trench isolation structure may electrically separate the first active area and the second active area. The method may further include forming two or more device elements in the second active area and electrically connecting the two or more device elements in series. The two or more device elements may be substantially arranged along a sidewall of the trench isolation structure, e.g. parallel to an extension direction of the sidewall.

The above methods may be applied for manufacturing the semiconductor devices as described with respect to any of the above embodiments or any of the embodiments described below in connection with the figures.

It will be appreciated that while the method is described above and below as a series of steps or events, the described ordering of such steps or events are not to be interpreted in a limiting sense. Rather, some steps may occur in different orders and/or concurrently with other steps or events apart from those described above and below. For example, the first and second trench isolation structures may be formed concurrently.

The embodiments described above may be combined in any way and will be further illustrated with respect to exemplary figures described below.

Functional and structural details described with respect to the embodiments above shall likewise apply to the exemplary figures below.

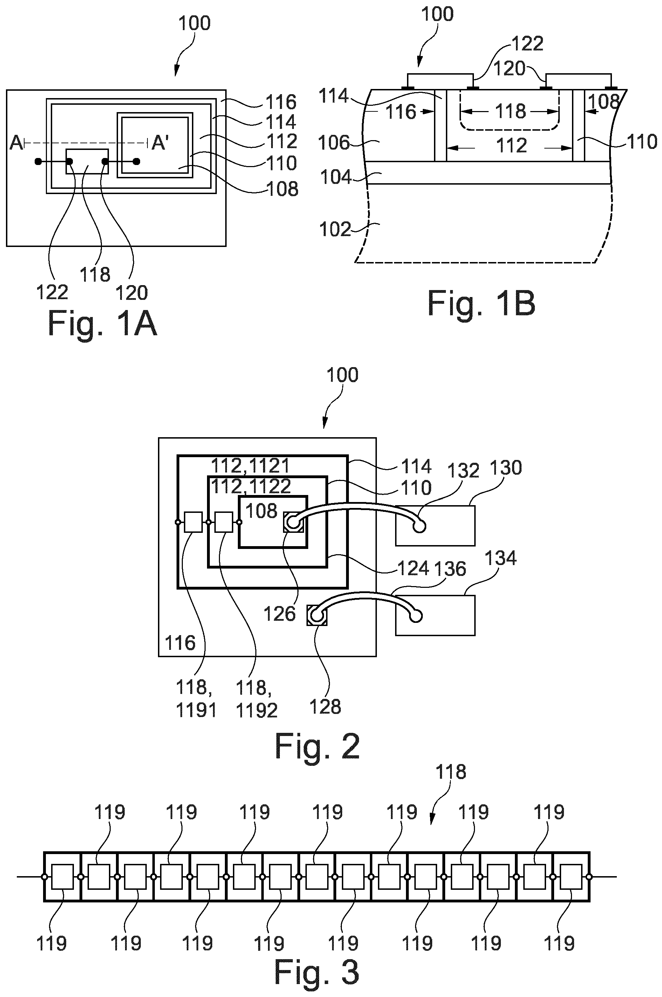

The schematic plan view of FIG. 1A illustrates an embodiment of a semiconductor device 100. The schematic cross-sectional view of FIG. 1B refers to the intersection line AA' of FIG. 1A.

Referring to FIGS. 1A and 1B, a semiconductor device 100 according an example not falling within the scope of the claimed invention includes a substrate 102. An isolation structure 104 is formed on the substrate 102. A first active area 108 is formed on the isolation structure 104. A protection area 112 is formed on the isolation structure 104 and laterally surrounds the first active area 108. A second active area 116 is formed on the isolation structure 104 and laterally surrounds the protection area 112. The first active area 108, the second active area 116 and the protection area 112 are parts of a semiconductor layer 106. The substrate 102, the isolation structure and the semiconductor layer 106 may be provided as a SOI substrate, for example. The substrate 102 may be removed, e.g. by grinding, etching or any other suitable process, during the production process to achieve a very thin semiconductor device with the isolation structure 104 as a lowermost layer for achieving a better thermal behavior of the semiconductor device.

A first trench isolation structure 110 electrically separates the first active area 108 and the protection area 112. A second trench isolation structure 114 electrically separates the protection area 112 and the second active area 116. The first and second trench isolation structures 110, 114 may extend up to the isolation structure 104 or through the isolation structure 104 or even into the substrate 102. A part of the filling of the trench isolation structure may be conductive material configured to be electrically connected to the substrate 102 at a bottom side of the trench isolation structure, for example.

The semiconductor device 100 further includes a protection structure 118 in the protection area 112. A first pin 120 of the protection structure 118 is electrically connected to the first active area 108 and a second pin 122 of the protection structure 118 is electrically connected to the second active area 116, e.g. by contact plugs and wiring lines.

Circuit elements may be formed in each of the first and second active areas 108, 116. As an example, a high side gate driver circuit may be formed in the first active area 108 and a low side gate driver circuit may be formed in the second active area 116.

A breakdown voltage or blocking voltage capability of the isolation structure 104 may be larger than a breakdown voltage or blocking voltage capability of each of the first and second trench isolation structures 110, 114, e.g. larger than a factor of 2, or larger than a factor of 3, or even larger than a factor of four. The breakdown or blocking voltage capability of the isolation structure 104 may be equal to or larger than a sum of the blocking voltages of the first and second trench isolation structures 110, 114 between the first and second active area 108, 116.

The schematic plan view of FIG. 2 illustrates another embodiment of semiconductor device not falling within the scope of the claimed invention.

In the semiconductor device 100 illustrated in FIG. 2, the protection area 112 comprises a pair of protection sub-areas. A first protection sub-area 1121 laterally surrounds a second protection sub-area 1122 of the pair. A first protection element 1181 of the protection structure 118 is formed in the first protection sub-area 1121, and a second protection element 1182 of the protection structure 118 is formed in the second protection sub-area 1122. The first and second protection elements 1191, 1192 are serially connected. The first and second protection elements 1191, 119 may correspond to one another with respect to protection device type and maximum voltage ratings, for example.

A fourth (trench isolation structure 124 is arranged between the first protection sub-area 1121 and the second protection sub-area 1122 and electrically separates the first protection sub-area 1121 and the second protection sub-area 1122.

The semiconductor device 100 further includes a first connection area 126, e.g. a bond pad area electrically connected to the first active area 108, and a second connection area 128, e.g. a bond pad area electrically connected to the second active area 126. The first connection area 126 is electrically connected to a first external connection area 130 by a first connector 132, e.g. a bond wire. The first external connection area 130 may be a bond pad area of another semiconductor chip, e.g. a High Side (HS) pin of a high power DC/DC converter or a high voltage (HV) motor drive. Likewise, the second connection area 128 is electrically connected to a second external connection area 134 by a second connector 136, e.g. a bond wire. The second external connection area 134 may be a bond pad area of the other semiconductor chip, for example. The connection areas 126 and 128 may also be used as connection points for flip-chip mounting technology.

Referring to the schematic view of an embodiment of the protection structure 118 illustrated in FIG. 3, the protection structure 118 comprises a plurality of protection elements 119 electrically connected in series. Each of the plurality of protection elements is laterally surrounded by a third trench isolation structure 138. Depending on the maximum voltage ratings of each protection element 119 and the breakdown voltage or blocking voltage capability of the third trench isolation structure 138, also a plurality of protection elements 119 may be surrounded by a same closed loop formed of the third trench isolation structure 138, for example.

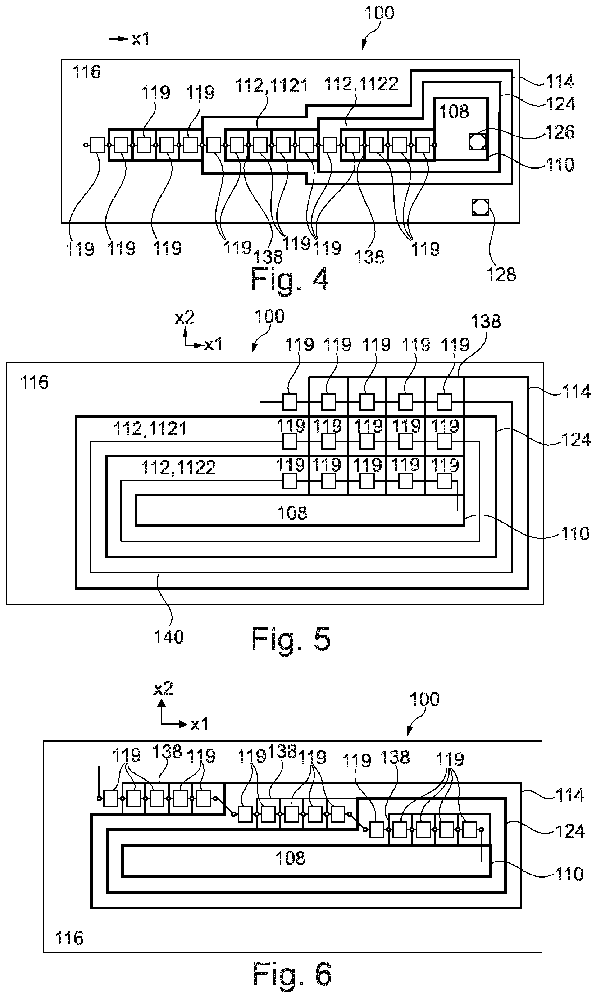

FIGS. 4 to 8 illustrate plan views of embodiments of the semiconductor device 100.

Referring to the schematic plan view of FIG. 4, a plurality of the protection elements 119 are consecutively arranged along a first lateral direction x1 and serially connected to one another along the first lateral direction x1. Protection elements 119 are not only arranged in the protection area 112, but also in the second active area 116.

The schematic plan views of FIGS. 5 and 6 illustrate embodiments of semiconductor devices 100 having a plurality of protection elements 119 in each of the second active area 116, the first protection sub-area 1121 and the second protection sub-area 1122. Protection elements 119 in the second active area 116 form a first group of protection elements 119. Protection elements 119 in the first protection sub-area 1121 form a second group of protection elements 119. Protection elements 119 in the second protection sub-area 1122 form a third group of protection elements 119. The arrangements of the protection elements 119 illustrated in FIGS. 5 and 6 are two examples where at least parts of the protection elements 119 of each group are consecutively arranged along the first lateral direction x1 but protection elements 119 of different groups are offset to each other along a second lateral direction x2 and electrically isolated by a trench isolation structure. The first lateral direction x1 may be parallel to equipotential lines associated with a potential difference between the first and second active areas during operation of the semiconductor device, for example. In the embodiment illustrated in FIG. 5, a wiring 140 for electrically connecting protection elements 119 of different groups to one another is wrapped around the first and second protection sub-areas 1121, 1122, respectively.

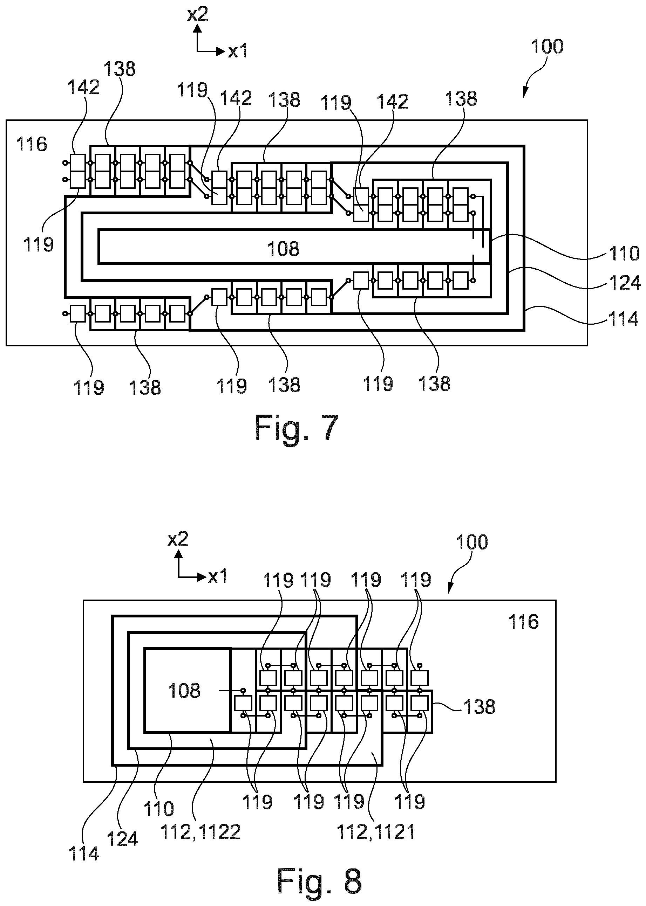

The embodiment illustrated in the schematic plan view of FIG. 7 is similar to the embodiment of FIG. 6 with respect to the geometric arrangement of the protection devices 119. However, the semiconductor device 100 of FIG. 7 includes not only a serial connection of protection elements 119, but also a parallel connection of two protection structures. In some other embodiments, more than two protection structures may be electrically connected in parallel, for example.

Moreover, the semiconductor device 100 illustrated in the FIG. 7 includes cascaded level shifter elements 142. One level shifter element 142 and one protection element 119 are surrounded by a common third trench isolation structure 138. Thus, the protection element 119 may limit the voltage over the level shifter element 142. According to other embodiments, the level shifter elements may also be electrically separated from the protection elements by a trench isolation structure, for example. A level shifter element may also be connected in parallel with a voltage limiting element, e.g. a Zener diode.

The schematic plan view of FIG. 8 illustrates an embodiment of the semiconductor devices 100 having a plurality of protection elements 119 arranged in a meandering configuration and serially connected to one another along the meandering configuration.

The protection elements 119 and level shifter elements 142 may be arranged in a variety of ways. A specific arrangement may be chosen depending on the breakdown voltage or blocking voltage capability of the trench isolation structures and the maximum voltage ratings of the protection elements 119 and level shifter elements 142, for example.

By way of example, a stack or chain of protection elements 190 or level shifter elements 142 may be laterally surrounded by trench isolation structures or other isolation structures and may be arranged in or around the area to be protected. The chain of stacked elements may be arranged in a way that a maximum isolation capability of a single separation/trench isolation structure is ensured in case that the voltage protection capability of a single protection element is lower than the isolation capability of the single separation/trench isolation structure. A geometric arrangement of the stacked protection elements may include handling of voltage differences in two orientations, for example. Along a first orientation, e.g. the second lateral direction x2 in the embodiment illustrated in FIG. 5, voltage differences between different areas, e.g. the first protection sub-area 1121 and the second protection sub-area 1122 are absorbed. Along a second orientation, e.g. the first lateral direction x1 in the embodiment illustrated in FIG. 5, the protection elements 119 are stacked to achieve protection for voltage differences that depend on the maximum voltage ratings of the manufacturing process technology. The wiring 140 may be placed over a separation/trench isolation structure to achieve a chain structure for the stacked protection elements. Thus, unprotected areas may be avoided and cascaded level shifter elements may be supported for data exchange between different active areas.

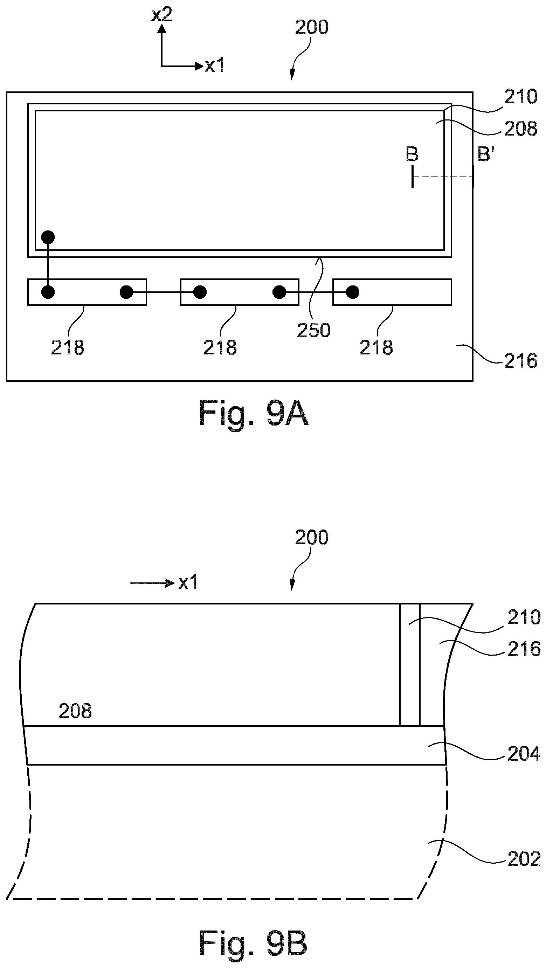

The schematic plan view of FIG. 9A illustrates an embodiment of a semiconductor device 200. The schematic cross-sectional view of FIG. 9B refers to the intersection line BB' of FIG. 9A.

Referring to FIGS. 9A and 9B, a semiconductor device 200 includes a substrate 202. An isolation structure 204 is formed on the substrate 202. A first active area 208 and a second active area 216 are formed on the isolation structure 204. A trench isolation structure 210 electrically separates the first active area 208 and the second active area 216. At least two device elements 218, e.g. level shifter elements or protection elements are formed in the second active area 216 and are connected in series. The at least two device elements 218 are arranged along a sidewall 250 of the trench isolation structure 210 parallel to an extension direction of the sidewall 250. In some other embodiments, a longitudinal direction of some or all of the device elements 218 may be arranged at a tilt angle with respect to an extension direction of the sidewall 250, for example. The device elements 218 may also adjoin one another. Likewise, all or some of the device elements may also directly adjoin the sidewall 250. Similar to the embodiment illustrated in FIG. 1B, the substrate 202 may be removed, e.g. by grinding, etching or any other suitable process, during the production process to achieve a very thin semiconductor device with the isolation structure 204 as a lowermost layer for achieving a better thermal behavior of the semiconductor device.

Circuit elements may be formed in each of the first and second active areas 208, 216, for example.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims.

## Claims

1. A semiconductor device (100), comprising:
an isolation structure (104);
a first active area (108) formed on the isolation structure (104);
a protection area (112) formed on the isolation structure (104) and laterally surrounding the first active area (108);
a second active area (116) formed on the isolation structure (104) and laterally surrounding the protection area (112);
a first trench isolation structure (110) electrically separating the first active area (108) and the protection area (112);
a second trench isolation structure (114) electrically separating the protection area (112) and the second active area (116); and
a protection structure (118) in the protection area (112), wherein a first pin (120) of the protection structure (118) is electrically connected to the first active area (108) and a second pin (122) of the protection structure (118) is electrically connected to the second active area (116),
**characterized in that** the protection structure (118) comprises a plurality of protection elements (119) consecutively arranged substantially along a sidewall of the first trench isolation structure (110) and serially connected to one another substantially along the sidewall of the first trench isolation structure (110),and each of or groups of the plurality of protection elements (119) are laterally surrounded by a closed-loop trench device isolation structure not surrounding the first active area (108).

2. The semiconductor device (100) of claim 1, wherein the device isolation structure comprises a third trench isolation structure (138), and a width of the third trench isolation structure (138) corresponds to a width of each of the first and second trench isolation structures (110, 114).

3. The semiconductor device (100) of any of the preceding claims, wherein
the protection area (112) comprises at least one pair of protection sub-areas,
a first protection sub-area (1121) of each pair of the at least one pair laterally surrounds a second protection sub-area (1122) of the respective pair; and the semiconductor device (100) further comprises
a fourth trench isolation structure (124) arranged between the first protection sub-area (1121) and the second protection sub-area (1122).

4. The semiconductor device (100) of claim 3, wherein the protection structure (118) comprises a first number of serially connected protection elements (119) in the first protection sub-area (1121) and a second number of serially connected protection elements (119) in the second protection sub-area (1122).

5. The semiconductor device (100) of claim 4, wherein the first number of protection elements (119) is consecutively arranged along the first lateral direction (x1), and the second number of protection elements (119) is consecutively arranged along the first lateral direction (x1) having a lateral offset to the first number of protection elements (119), and wherein the lateral offset is an offset along a second lateral direction (x2) perpendicular to the first lateral direction (x1).

6. The semiconductor device of any of the preceding claims, further comprising:
a level shifter structure in the protection area (112).

7. The semiconductor device of any of the preceding claims, further comprising:
a high side gate driver circuit in the first active area (108); and
a low side gate driver circuit in the second active area (116).

8. The semiconductor device of claim 1, wherein a part of the closed-loop trench device isolation structure of at least one of the plurality of protection elements (119) corresponds to a part of the first trench isolation structure (110).

9. A method of manufacturing a semiconductor device (100), the method comprising:
providing a semiconductor body comprising an isolation structure (104), a first active area (108) formed on the isolation structure (104), a protection area (112) formed on the isolation structure (104) and laterally surrounding the first active area (108), and a second active area (116) formed on the isolation structure (104) and laterally surrounding the protection area (112);
forming a first trench isolation structure (110), wherein the first trench isolation structure (110) electrically separates the first active area (108) and the protection area (112);
forming a second trench isolation structure (114), wherein the second trench isolation structure (110) electrically separates the protection area (112) and the second active area (116);
forming a protection structure (118) in the protection area (112), wherein the protection structure (118) comprises a plurality of protection elements (119) consecutively arranged substantially along a sidewall of the first trench isolation structure (110) and serially connected to one another substantially along the sidewall of the first trench isolation structure (110);
electrically connecting a first pin (120) of the protection structure (118) to the first active area (108); and
electrically connecting a second pin (122) of the protection structure (118) to the second active area (116), wherein the method further comprises forming a closed-loop trench device isolation structure laterally surrounding each of or groups of the plurality of protection elements (119) and not surrounding the first active area (108).

## Patentansprüche

1. Halbleiterelement (100), umfassend:
eine Isolationsstruktur (104);
eine erste aktive Fläche (108), die auf der Isolationsstruktur (104) ausgebildet ist;
eine Schutzfläche (112), die auf der Isolationsstruktur (104) ausgebildet ist und die erste aktive Fläche (108) seitlich umgibt;
eine zweite aktive Fläche (116), die auf der Isolationsstruktur (104) ausgebildet ist und die Schutzfläche (112) seitlich umgibt;
eine erste Grabenisolationsstruktur (110), die die erste aktive Fläche (108) und die Schutzfläche (112) elektrisch trennt;
eine zweite Grabenisolationsstruktur (114), die die Schutzfläche (112) und die zweite aktive Fläche (116) elektrisch trennt; und
eine Schutzstruktur (118) in der Schutzfläche (112), wobei ein erster Kontakt (120) der Schutzstruktur (118) elektrisch mit der ersten aktiven Fläche (108) verbunden ist und ein zweiter Kontakt (122) der Schutzstruktur (118) elektrisch mit der zweiten aktiven Fläche (116) verbunden ist,
**dadurch gekennzeichnet, dass**
die Schutzstruktur (118) eine Mehrzahl von Schutzelementen (119) umfasst, die fortlaufend im Wesentlichen entlang einer Seitenwand der ersten Grabenisolationsstruktur (110) angeordnet und seriell miteinander im Wesentlichen entlang der Seitenwand der ersten Grabenisolationsstruktur (110) verbunden sind, und jedes oder Gruppen der Mehrzahl von Schutzelementen (119) seitlich von einer geschlossenen Graben-Vorrichtungsisolationsstruktur umgeben sind, die die erste aktive Fläche (108) nicht umgibt.

2. Halbleiterelement (100) nach Anspruch 1, wobei die Vorrichtungsisolationsstruktur eine dritte Grabenisolationsstruktur (138) umfasst, und eine Breite der dritten Grabenisolationsstruktur (138) einer Breite jeder der ersten und zweiten Grabenisolationsstrukturen (110, 114) entspricht.

3. Halbleiterelement (100) nach einem der vorhergehenden Ansprüche, wobei
die Schutzfläche (112) mindestens ein Paar Schutzteilflächen umfasst,
eine erste Schutzteilfläche (1121) jedes Paars des mindestens einen Paars seitlich eine zweite Schutzteilfläche (1122) des jeweiligen Paars umgibt; und das Halbleiterelement (100) ferner umfasst eine vierte Grabenisolationsstruktur (124), die zwischen der ersten Schutzteilfläche (1121) und der zweiten Schutzteilfläche (1122) angeordnet ist.

4. Halbleiterelement (100) nach Anspruch 3, wobei die Schutzstruktur (118) eine erste Anzahl von seriell verbundenen Schutzelementen (119) in der ersten Schutzteilfläche (1121) und eine zweite Anzahl von seriell verbundenen Schutzelementen (119) in der zweiten Schutzteilfläche (1122) umfasst.

5. Halbleiterelement (100) nach Anspruch 4, wobei die erste Anzahl von Schutzelementen (119) fortlaufend entlang der ersten lateralen Richtung (x1) angeordnet ist, und die zweite Anzahl von Schutzelementen (119) fortlaufend entlang der ersten lateralen Richtung (x1) mit einem lateralen Versatz zu der ersten Anzahl von Schutzelementen (119) angeordnet ist, und wobei der laterale Versatz ein Versatz entlang einer zweiten lateralen Richtung (x2) rechtwinklig zu der ersten lateralen Richtung (x1) ist.

6. Halbleiterelement nach einem der vorhergehenden Ansprüche, ferner umfassend:
eine Pegelwandlerstruktur in der Schutzfläche (112).

7. Halbleiterelement nach einem der vorhergehenden Ansprüche, ferner umfassend:
eine High-Side-Gate-Treiberschaltung in der ersten aktiven Fläche (108); und
eine Low-Side-Gate-Treiberschaltung in der zweiten aktiven Fläche (116).

8. Halbleiterelement nach Anspruch 1, wobei ein Teil der geschlossenen Graben-Elementisolationsstruktur von mindestens einem der Mehrzahl von Schutzelementen (119) einem Teil der ersten Grabenisolationsstruktur (110) entspricht.

9. Verfahren zum Herstellen eines Halbleiterelements (100), wobei das Verfahren umfasst:
Bereitstellen eines Halbleiterkörpers, umfassend eine Isolationsstruktur (104), eine erste aktive Fläche (108), die auf der Isolationsstruktur (104) ausgebildet ist, eine Schutzfläche (112), die auf der Isolationsstruktur (104) ausgebildet ist und die erste aktive Fläche (108) seitlich umgibt, und eine zweite aktive Fläche (116), die auf der Isolationsstruktur (104) ausgebildet ist und die Schutzfläche (112) seitlich umgibt;
Ausbilden einer ersten Grabenisolationsstruktur (110), wobei die erste Grabenisolationsstruktur (110) die erste aktive Fläche (108) und die Schutzfläche (112) elektrisch trennt;
Ausbilden einer zweiten Grabenisolationsstruktur (114), wobei die zweite Grabenisolationsstruktur (110) die Schutzfläche (112) und die zweite aktive Fläche (116) elektrisch trennt;
Ausbilden einer Schutzstruktur (118) in der Schutzfläche (112), wobei die Schutzstruktur (118) eine Mehrzahl von Schutzelementen (119) umfasst, die fortlaufend im Wesentlichen entlang einer Seitenwand der ersten Grabenisolationsstruktur (110) angeordnet und seriell miteinander im Wesentlichen entlang der Seitenwand der ersten Grabenisolationsstruktur (110) verbunden sind;
elektrisches Verbinden eines ersten Kontakts (120) der Schutzstruktur (118) mit der ersten aktiven Fläche (108); und
elektrisches Verbinden eines zweiten Kontakts (122) der Schutzstruktur (118) mit der zweiten aktiven Fläche (116), wobei das Verfahren ferner das Ausbilden einer geschlossenen Graben-Elementisolationsstruktur umfasst, die seitlich jedes oder Gruppen der Mehrzahl von Schutzelementen (119) umgibt und die erste aktive Fläche (108) nicht umgibt.

## Revendications

1. Un dispositif (100) à semiconducteur, comprenant :
une structure (104) d'isolation ;
une première zone (108) active formée sur la structure (104) d'isolation ;
une zone (112) de protection formée sur la structure (104) d'isolation et entourant latéralement la première zone (108) active ;
une deuxième zone (116) active formée sur la structure (104) d'isolation et entourant latéralement la zone (112) de protection ;
une première structure (110) d'isolation à tranchée séparant électriquement la première zone (108) active et la zone (112) de protection ;
une deuxième structure (114) d'isolation à tranchée séparant électriquement la zone (112) de protection et la deuxième zone (116) active ; et
une structure (118) de protection dans la zone (112) de protection, dans lequel une première broche (120) de la structure (118) de protection est connectée électriquement à la première zone (108) active et une deuxième broche (122) de la structure (118) de protection est connectée électriquement à la deuxième zone (116) active,
**caractérisé en ce que**
la structure (118) de protection comprend une pluralité d'éléments (119) de protection disposés consécutivement sensiblement le long d'une paroi latérale de la première structure (110) d'isolation à tranchée et montés en série les uns aux autres sensiblement le long de la paroi latérale de la première structure (110) d'isolation à tranchée, et chacun des groupes de la pluralité d'éléments (119) de protection sont entourés latéralement d'une structure d'isolation de dispositif à tranchée en boucle fermée n'entourant pas la première zone (108) active.

2. Le dispositif (100) à semiconducteur de la revendication 1, dans lequel la structure d'isolation de dispositif comprend une troisième structure (138) d'isolation à tranchée, et une largeur de la troisième structure (138) d'isolation à tranchée correspond à une largeur de chacune de la première et de la deuxième structures (110, 114) d'isolation à tranchée.

3. Le dispositif (100) à semiconducteur de l'une quelconque des revendications précédentes, dans lequel
la zone (112) de protection comprend au moins une paire de sous-zones de protection,
une première sous-zone (1121) de protection de chaque paire de la au moins une paire entoure latéralement une deuxième sous-zone (1122) de protection de la paire respective ; et le dispositif (100) à semiconducteur comprend en outre
une quatrième structure (124) d'isolation à tranchée disposée entre la première sous-zone (1121) de protection et la deuxième sous-zone (1122) de protection.

4. Le dispositif (100) à semiconducteur de la revendication 3, dans lequel la structure (118) de protection comprend un premier nombre d'éléments (119) de protection montés en série dans la première sous-zone (1121) de protection et un deuxième nombre d'éléments (119) de protection montés en série dans la deuxième sous-zone (1122) de protection.

5. Le dispositif (100) à semiconducteur de la revendication 4, dans lequel le premier nombre d'éléments (119) de protection est disposé consécutivement le long de la première direction (x1) latérale, et le deuxième nombre d'éléments (119) de protection est disposé consécutivement le long de la première direction (x1) latérale en ayant un décalage latéral par rapport au premier nombre d'éléments (119) de protection, et dans lequel le décalage latéral est un décalage le long d'une deuxième direction (x2) latérale perpendiculaire à la première direction (x1) latérale.

6. Le dispositif à semiconducteur de l'une quelconque des revendications précédentes, comprenant en outre :
une structure de changement de niveau dans la zone (112) de protection.

7. Le dispositif à semiconducteur de l'une quelconque des revendications précédentes, comprenant :
un circuit d'attaque de grille de niveau haut dans la première zone (108) active ; et
un circuit d'attaque de grille de niveau bas dans la deuxième zone (116) active.

8. Le dispositif à semiconducteur de la revendication 1, dans lequel une partie de la structure d'isolation de dispositif à tranchée en boucle fermée d'au moins l'un de la pluralité d'éléments (119) de protection correspond à une partie de la première structure (110) d'isolation à tranchée.

9. Un procédé de fabrication d'un dispositif (100) à semiconducteur, le procédé comprenant :
se procurer un corps à semiconducteur comprenant une structure (104) d'isolation, une première zone (108) active formée sur la structure (104) d'isolation, une zone (112) de protection formée sur la structure (104) d'isolation et entourant latéralement la première zone (108) active et une deuxième zone (116) active formée sur la structure (104) d'isolation et entourant latéralement la zone (112) de protection ;
former une première structure (110) d'isolation à tranchée, dans lequel la première structure (110) d'isolation à tranchée sépare électriquement la première zone (108) active et la zone (112) de protection ;
former une deuxième structure (114) d'isolation à tranchée, dans lequel la deuxième structure (110) d'isolation à tranchée sépare électriquement la zone (112) de protection et la deuxième zone (116) active ;
former une structure (118) de protection dans la zone (112) de protection, dans lequel la structure (118) de protection comprend une pluralité d'éléments (119) de protection disposés consécutivement sensiblement le long d'une paroi latérale de la première structure (110) d'isolation à tranchée et montés en série les uns avec les autres sensiblement le long de la paroi latérale de la première structure (110) d'isolation à tranchée ;
connecter électriquement une première broche (120) de la structure (118) de protection à la première zone (108) active ; et
connecter électriquement une deuxième broche (122) de la structure (118) de protection à la deuxième zone (116) active, dans lequel le procédé comprend en outre former une structure d'isolation de dispositif à tranchée en boucle fermée entourant latéralement chacun des groupes de la pluralité d'éléments (119) de protection et n'entourant pas la première zone (108) active.
